Europäisches Patentamt

European Patent Office

Office européen des brevets

(11) Publication number: 0 351 169
A2

# (12) EUROPEAN PATENT APPLICATION

(21) Application number: 89306983.1

(22) Date of filing: 10.07.89

(51) Int. Cl.4: G03G 15/00 , G03F 7/00

(30) Priority: 11.07.88 JP 172335/88

(43) Date of publication of application:
17.01.90 Bulletin 90/03

(84) Designated Contracting States:
DE FR GB

(71) Applicant: BROTHER KOGYO KABUSHIKI
KAISHA
35, Horita-dori 9-chome Mizuho-ku
Nagoya-shi, Aichi 467(JP)

(72) Inventor: Hayakawa, Kiyoharu Brother Kogyo
K.K.
35, Horita-dori 9-chome Mizuho-ku
Nagoya-shi Aichi-ken(JP)
Inventor: Okamoto, Tsugio Brother Kogyo K.K.
35, Horita-dori 9-chome Mizuho-ku
Nagoya-shi Aichi-ken(JP)

(74) Representative: Senior, Alan Murray et al
J.A. KEMP & CO 14 South Square Gray's Inn
London WC1R 5EU(GB)

(54) Imaging device.

(57) In an imaging device such as a duplicating machine employing a continuous-form photo and pressure-sensitive recording medium and being arranged in such a manner that the recording medium is exposed based upon an original, further pressurized with a pair of rollers to develop a visible image, provided are a plurality of drive means such as motors for independently driving rollers to travel the recording medium with an exposure operation and a pair of pressure rollers to pressure the exposed recording medium.

Thus, the exposure operation is evenly executed on an area to be exposed regardless of a load fluctuations with a pressurizing operation executed by the rollers.

FIG.1

## Imaging Device

This present invention relates to an imaging device employing a photo and pressure-sensitive recording medium,

A known imaging device forwards a rolled continuous-form photo and pressure-sensitive recording medium through an exposure unit for exposing the recording medium to form a latent image thereon, a pressure-developing unit for pressurize the exposed recording medium to develop a visible image, and a heat fixing unit for fixing the visible image by heat. Forwarding is by one and the same motor in order that the pressure-developing process is executed simultaneously with the exposure process.

With respect to the pressure-developing operation, the winding operation of the photo and pressure-sensitive recording medium and the like, however, fluctuations in the feed rate are unavoidable as the load conditions of the driving means due to pressure developing or take up of recording medium greatly fluctuates despite the fact that the feed rate is controlled. For this reason, the feed rate in the exposure unit driven by the same motor also fluctuates and unenvenness and deflection of exposure are caused thereby .

An imaging device is generally expected to offer high image quality and consequently the feed rate in the exposure unit has to be kept uniform. On the other hand, it still remains difficult to eliminate fluctuations in the speed of the motor caused by fluctuations of the load conditions.

According to this invention, there is provided an imaging device employing a photo and pressure sensitive recording medium including

exposure means for exposing an optical image on said recording medium;

pressure-developing means for pressurizing said recording medium exposed by said exposure means to develop a visible image;

travel means for forwarding said recording medium first drive means for driving said pressure-developing means so as to pressurize said recording medium; and

second drive means for separately driving said travel means.

The invention provides different drive sources for the pressure rollers and the forwarding means so that forwarding speed fluctuates less.

The invention will be better understood from the following description, given by way of example only, with reference to the accompanying drawings in which:-

Fig. 1 is a schematic sectional view of a photo and pressure-sensitive duplicating machine employing an arrrangement according to the present invention;

Fig. 2(A) is a block diagram showing one embodiment of a drive system for the duplicating machine of Fig. 1;

Fig. 2(B) is a block diagram showing an another embodiment of a drive system for the duplicating machine of Fig. 1; and

Fig. 3(A) and 3(B) are illustrative views showing arrangements of the elements included in the drive system of Fig. 2(A) and 2(B).

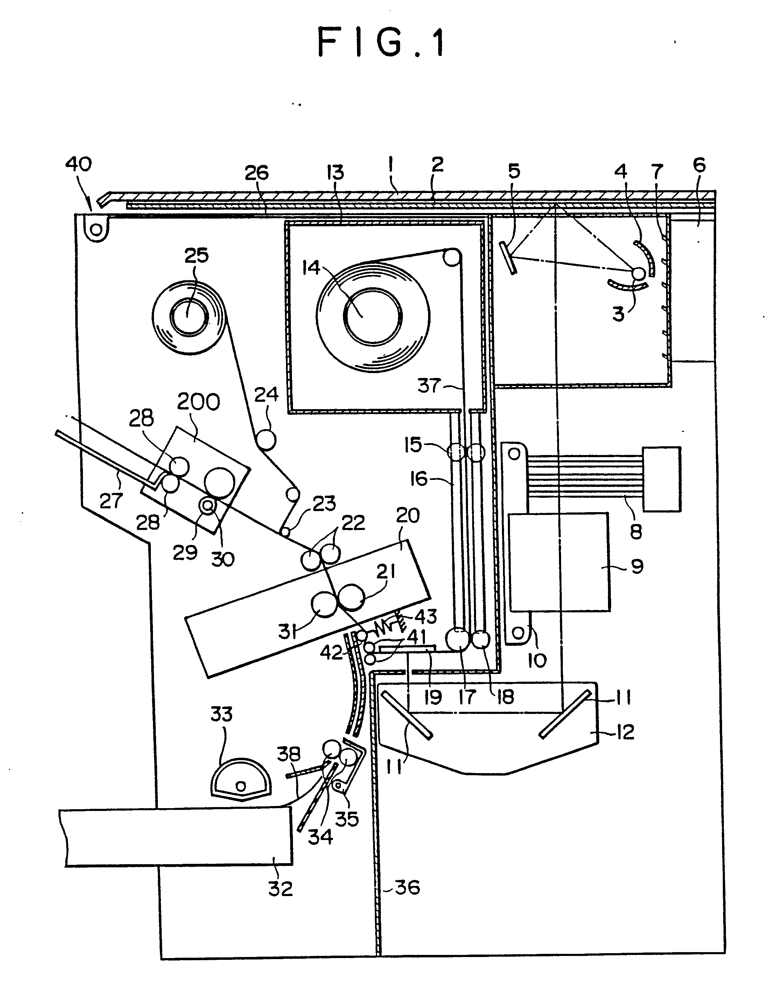

Fig. 1 is a schematic sectional view of a full-colour duplicating machine 40 incorporating a drive system embodying the present invention. Incidentally, a transfer type image recording medium comprising microcapsule sheet coated with a plurality of photo-sensitive microcapsules and developing sheet coated with a developing material is already known, in Japanese Patent Provisional Publication SHO58-88739 and the like.

As shown in Fig. 1, the duplicating machine 40 includes a glass tray 2 and a tray cover 1 reciprocally movable leftward and rightward, and a desired original may be placed upside down on the glass tray 2. Secured to the upper right portion of the machine 40 is a light source comprising a halogen lamp 3 extending in the direction perpendicular to that in which the glass tray 2 moves, and a semi-cylindrical reflection mirror 4 located so as to surround the lamp 3. The light emitted from the lamp 3 is thus linearly incident upon the glass tray 2.

As the glass tray 2 reciprocates, the whole surface of the glass tray 2 ranging from its leftmost to rightmost end can be irradiated successively with the light emitted from the halogen lamp 3. The light emitted from the light source passes through the transparent glass tray 2 and is reflected from the original placed thereon. Further, the surface of the glass tray is covered with the tray cover 1 to prevent the light thus applied form leaking along the original.

In order to utilize the light emitted from the halogen lamp 3 efficiently for irradiating the original, a reflector 5 is disposed to the left of the light source so that the light not directly sent to the original is reflected therefrom and used to irradiate the original again.

A fan 6 and a louver 7 are provided to the right of the halogen lamp 3 to take air in from the outside, whereby the air is efficiently applied to the glass tray 2. This allows the glass tray 2 to be well cooled.

The light emitted from the halogen lamp 3 and reflected from the original located on the glass tray 2 is led to a lens system 9 through a filter 8. The filter 8 is provided with at least three filter sections, each section selectively passing the light which has a wavelength corresponding to the sensitivity of one of at least three groups of microcapsules of a continuous-form recording medium 37 so as to adjust tonality of the duplicated image. The lens system 9 is mounted on a lens mount plate 10 in such a manner that fine angle adjustment is made possible with respect to the optical path thereof. The light condensed by the lens system 9 is turned at an angle of 180 degrees by a pair of opposedly arranged reflection mirrors 11, 11, and focused on the recording medium 37 which is in close contact with the undersurface of an exposure tray 19. The two reflection mirrors 11, 11 are secured to a mirror mount plate 12 so that adjustment of the optical path and focusing takes place by fine adjustment of the position of the mirror mount plate 12.

On the other hand, the continuous-form recording sheet 37 wrapped around a detachable cartridge shaft 14 is housed in a housing 13 positioned under the glass tray 2, one end of the sheet of the paper reaching a take-up shaft 25 via multiple rollers and a pressure-developing unit 20.

The recording medium 37 led out from the underside of the housing 13 is guided along the undersurface of the exposure tray 19 by means of feed rollers 15 and guide rollers 17, 18 and further fed to the pressure-developing unit 20 through feed rollers 41 and a tension roller 42. The tension roller 42 is secured to the duplicating machine body through a tension spring 43. The recording sheet 37 passed through the pressure-developing unit 20 is then guided by a separation roller 23 and a winding run adjustment roller 24, and is taken up onto the take-up shaft 25. The unexposed recording sheet 37 leaving the cartridge 13 is protected against light by means of a shield cover 16.

The recording sheet 37 is controlled by sheet feed rollers 22, 22to be forwarded at a constant feed rate in synchronism with the reciprocal movement speed of the glass tray 2. Thus, a latent image of a predetermined line on the original is successively formed on the recording shet 37 while it is passed through the exposure tary 19.

Moreover, a developing sheet casette 32 for accomodating cut-sheet type developing sheets is located upstream of the developing unit 20. The developing sheets 38 are picked out by means of a semi-cylindrical roller 33 and carried to the paper inlet of the pressure-developing unit 20 after the front end of each sheet is registered by means of developing sheet rollers 34, 34 and a swingable resist gate 35.

As a result, the microcapsule sheet 37 and the developing-sheet 38 are fed to the pressure-developing unit 20 in a superposed state. The pressure-developing unit 20 comprises a pair of pressure rollers 21 and 31. While the microcupsule side, on which the latent image is formed, of the recording medium 37 and the developer-coated side of the developing sheet 38 contact face-to-face on their inside, both the sheets are pinched and pressurized together in between the pair of pressure rollers 21 and 31. With the pressurizing thus applied, the microcapsules remaining unexposed are crushed to develop a visible image on the developing sheet 38.

The recording sheet 37 and the developing sheet 38 when led out of the pressure-developing unit 20 are carried by the sheet feed rollers 22, 22 and then separated from each other in such a manner that the former is turned upward while the latter proceeds straight. The developed image on the developing sheet 38 is fixed by means of a thermal fixing unit 200 and the developing sheet 38 is discharged to a sheet outlet tray 27, with the image-carrying side facing up. The heat fixing unit 200 comprises a hollow heat roller 29 having a heater 30 therein and a pair of developing sheet feed rollers 28, 28.

The recording medium 37 thus separated is wound onto the take-up shaft 25 through the winding run adjustment roller 24.

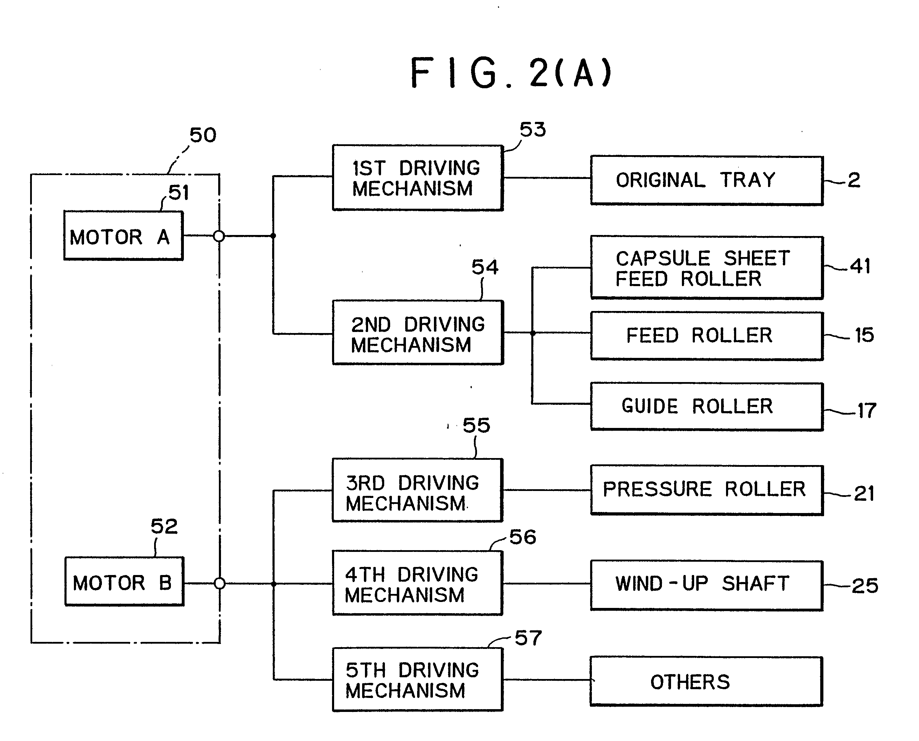

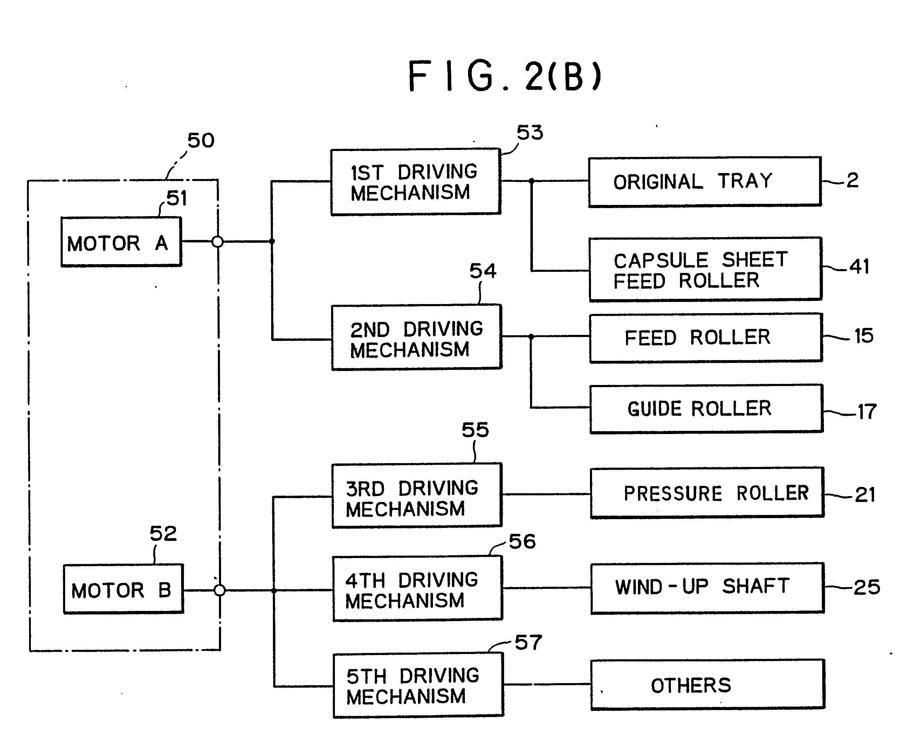

A drive system 50 in this embodiment comprises, as shown in Fig. 2(A), a motor-A 51 and a motor-B 52. The rotary shaft of the motor-A 51 is connected to a first driving mechanism 53 for moving the glass tray 2 and a second driving mechanism 54 for rotating the feed rollers 41, the feed rollers 15 and the guide rollers 17. Moreover, the rotary shaft of the motor-B 52 is connected to a third driving mechanism 55 for rotating one of the pair of pressure rollers 21, a fourth driving mechanism 55 for rotating the take-up shaft 25 and a fifth driving mechanism 57 for driving the other elements mechanically operated.

The operation of the duplicating machine thus constructed will be described.

When a start button, provided on the machine 40, not shown, is pressed down after an original is placed on the glass tray 2, with the tary cover 1 opened, the glass tray 2 is moved rightward in Fig. 1 and brought to a stop position where the leftmost end thereof is located opposite to the light source. The glass tray 2 is moved left while the halogen lamp 3 is reflected from the original and then passed through the filter 8 and the lens system 9 before being reflected from the two reflection mirrors 11, 11 to form a latent image on the recording medium 37 placed under the exposure tray 19. Since the recording sheet 37 moves leftward along the exposure tary 19 at the same speed as that of the traveling glass tray 2 at that time, a latent image corresponding to the image on the original is formed on the recording sheet 37.

With the leftward movement of the glass tray 2, the developing sheet 38 taken out by the semi-cylindrical roller 33 from the developing sheet cassette 32 is superposed on the already exposed microcapsule sheet 37, the combination of these sheets being fed to the pressure-developing unit 20. The latent image on the microcapsule sheet 37 is then developed to a visible image and transferred onto the developing sheet 38.

When the developing sheet 38 is nipped in the pressure-developing unit 20 to start a pressure-developing operation, a great fluctuation in motor torque may occur and thus cause fluctuations in a rotation speed of the motor B 52. Although the recording medium 37 is fed unevenly in the pressure-developing unit 20 in this case, uneven exposure can be prevented since an exposure system provided before the pressure-developing unit 20 is driven by the motor-A 51 independently driven from the motor-B 52. In addition, the difference in speed of the microcapsule sheet 37 between the feed roller 41 and the pressure-developing unit 20 is absorbed as the tension roller 42 changes its position in a direction along which the recording medium 37 travelled. The developing sheet 38 is subjected to heat fixation by a thermal fixing unit 200 and discharged from the duplicating machine 40 to the sheet outlet tray 27 with the image-carrying side facing up. The recording medium 37 passed through the pressure-developing unit 20 is successively taken onto the take-up shaft 25. When the glass tray 2 has moved up to the position where its rightmost end is located opposite to the light source, movement is completed and the halogen lamp 3 is turned off.

The present invention is not limited to the embodiment described above in detail but may be modified in various ways without departing from the spirit and the scope of the invention.

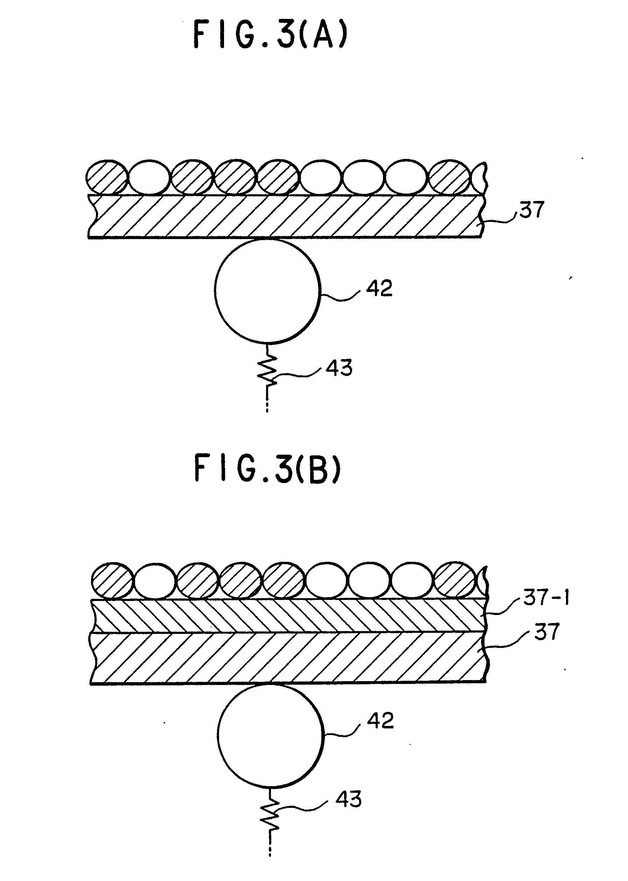

Although it has been arranged that the feed rollers 15, the guide roller 17 and the rollers 41 for feeding the capsule paper are driven by the motor-A 51, for instance, as shown in Fig. 2(B), the motor-A 51 may be used to drive the feed roller 41 for feeding the recording medium 37 and the glass tray 2. The tension roller 42 is arranged to be brought into contact with the capsule-coated side of the recording medium 37 solely for the convenience of arranging the machine members in this embodiment as shown in Fig. 3(A), moreover, the unnecessary breakage of the microcapsule can be prevented by making the tension roller contact the rear side thereof. If a self-developing type recording sheet including a developing material layer 37-1 is employed as the recording medium 37, the tension roller 42 can be arranged as shown in Fig. 3(B).

## Claims

1. An imaging device employing a photo and pressure sensitive recording medium including:

exposure means for exposing an optical image on said recording medium;

pressure-developing means for pressurizing said recording medium exposed by said exposure means to develop a visible image;

travel means for forwarding said recording medium first drive means for driving said pressure-developing means so as to pressurize said recording medium; and

second drive means for separately driving said travel means.

2. An imaging device according to claim 1 wherein said pressure-developing means comprises a pair of pressure rollers adapted to be brought into and out of contact with each other.

3. An imaging device according to claim 1 or 2 adapted for use with a recording medium which comprises a continuous-form recording sheet coated with microcapsules containing a chromogenic material and a photo-sensitive resin and a cut-sheet type developing sheet coated with a developer material, said developing sheet being in use pressurized with said exposed recording sheet by said pair of pressure rollers so as to develop a visible image thereon.

4. An imaging device according to claim 3 wherein said travel means includes a feed roller for feeding said recording medium.

5. An imaging device according to claim 3 or 4 which further comprises a take-up roller for taking-up said recording sheet having been pressurized by said pair of pressure rollers and wherein said first drive means further drives said take-up roller.

6. An imaging device according to claim 3, 4 or 5 which further comprises speed adjust means for adjusting the forwarding speed of said recording sheet to be constant between said exposure means and said pair of pressure rollers irrespective of operation of said pair of pressure rollers.

7. An imaging device according to claim 6 wherein said speed adjust means comprises a tension roller provided between said exposure means and said pair of pressure rollers, and adapted to be brought into contact with a surface of said recording medium, said tension roller being movable in a direction along which said recording sheet is forwarded.

8. An imaging device according to claim 7 wherein in use said surface in contact with said tension roller is the surface not coated with photosensitive material.

# FIG.1

# F I G. 2(A)

EP 0 351 169 A2

```
┌──────────────────────────┐                    ┌─────────────────┐ 53        ┌─────────────────────┐
│              50           │            ┌──────│ 1ST DRIVING     │──────────│  ORIGINAL  TRAY     │── 2
│         51   /            │            │       │ MECHANISM       │           └─────────────────────┘
│   ┌──────────────┐        │            │       └─────────────────┘
│   │              │        │            │                                    ┌─────────────────────┐
│   │   MOTOR  A   │───○────┼────●───────┤                        54          │  CAPSULE  SHEET     │── 41
│   │              │        │            │                  /                 │  FEED  ROLLER       │
│   └──────────────┘        │            │       ┌─────────────────┐          └─────────────────────┘
│                           │            └──────│ 2ND DRIVING     │──●────
│                           │                    │ MECHANISM       │    │     ┌─────────────────────┐
│                           │                    └─────────────────┘    ├────│  FEED  ROLLER       │── 15
│                           │                                           │     └─────────────────────┘
│                           │                              55           │
│                           │                               /           │     ┌─────────────────────┐
│                           │                    ┌─────────────────┐    └────│  GUIDE  ROLLER      │── 17
│                           │            ┌──────│ 3RD DRIVING     │          └─────────────────────┘
│                           │            │       │ MECHANISM       │
│        52                 │            │       └─────────────────┘          ┌─────────────────────┐
│         /                 │            │                              ──────│  PRESSURE  ROLLER   │── 21
│   ┌──────────────┐        │            │                  56               └─────────────────────┘
│   │              │        │            │                   /
│   │   MOTOR  B   │───○────┼────●───────┤       ┌─────────────────┐          ┌─────────────────────┐
│   │              │        │            │──────│ 4TH DRIVING     │──────────│  WIND - UP  SHAFT   │── 25
│   └──────────────┘        │            │       │ MECHANISM       │           └─────────────────────┘
│                           │            │       └─────────────────┘
└──────────────────────────┘            │                  57
                                         │                   /
                                         │       ┌─────────────────┐          ┌─────────────────────┐
                                         └──────│ 5TH DRIVING     │──────────│     OTHERS          │
                                                 │ MECHANISM       │          └─────────────────────┘
                                                 └─────────────────┘
```

# FIG. 2(B)

# FIG.3(A)

37

42

43

# FIG.3(B)

37-1

37

42

43